Europäisches Patentamt

(19) European Patent Office

Office européen des brevets

(11) Publication number: **0 052 054**
A1

## (12) EUROPEAN PATENT APPLICATION

(21) Application number: 81401759.6

(22) Date of filing: 03.11.81

(51) Int. Cl.³: **H 01 L 23/30**, H 01 L 23/48 // H01L23/36

(30) Priority: 10.11.80 US 205541

(43) Date of publication of application: 19.05.82 Bulletin 82/20

(84) Designated Contracting States: DE FR GB IT NL

(71) Applicant: FAIRCHILD CAMERA & INSTRUMENT CORPORATION, 464 Ellis Street, Mountain View California 94042 (US)

(72) Inventor: Phy, William S., 25616 Moody Road, Los Altos Hills California, 94022 (US)

(74) Representative: Chareyron, Lucien et al, Schlumberger Limited Service Brevets 42, rue Saint-Dominique, F-75340 Paris Cedex 07 (FR)

(54) Packaged semiconductor device which provides for enhanced power dissipation.

(57) A packaged semiconductor device which provides for enhanced power dissipation is disclosed. The packaged semiconductor device includes a mounting pad which is formed from a material having a thermal conductivity which is within about 20 % that of copper and a coefficient of thermal expansion which is within about 20 % that of silicon. A semiconductor device is mounted on the mounting pad. A plurality of metal leads having short lead fingers extend into close proximity to the mounting pad. The leads are electrically connected to the semiconductor device. An encapsulation encloses the mounting pad and the semiconductor device and extends laterally beyond the lead fingers such that the ends of the leads extend from the encapsulation as connectors for the packaged semiconductor device.

F-1471

PACKAGED SEMICONDUCTOR DEVICE WHICH

PROVIDES FOR ENHANCED POWER DISSIPATION

by

William S. Phy

BACKGROUND OF THE INVENTION

1.    Field of the Invention

The present invention relates generally to a packaged semiconductor device and particularly to a packaged semiconductor device which provides for enhanced power dissipation.

2.    Background of the Invention

Conventional transfer molded epoxy and silicone dual in-line packages for semiconductor devices offer major cost advantages over ceramic or metallic packages at the expense of high thermal impedence.  Recent developments in the field of metallurgy have resulted in the availability of materials having a thermal conductivity which approaches that of copper (2700 BTU/sq. ft./hr./$^{\circ}$F./in.) and a coefficient of thermal expansion which approximates that of silicon (1.8 x $10^{-6}$ in./in./$^{\circ}$F.).

The close match of expansion coefficient permits die attach of silicon integrated circuit devices to the material by use of conventional interface metals or alloys without cracking or otherwise degrading the electrical properties of the device due to the effects of mechanical stress.

-2-

The present invention provides a new package structure for a semiconductor device which is based upon existing and widely used lead frame techniques for plastic packages, which new structure provides lower thermal impedance than conventional package structures. A preferred structure provides lower junction to ambient $\theta_{JA}$ temperature rise in terms of degrees Centigrade per watt than commonly used ceramic dual in-line counterparts.

While cost to manufacture the new package is somewhat higher than present plastic dual in-line packages, a significant cost advantage over existing ceramic dual in-line packages is realized.


## SUMMARY OF THE INVENTION

A general object of the invention is to provide an improved package for a semiconductor device.

This and other objects are attained, in accordance with one aspect of the invention by a packaged semiconductor device comprising a mounting pad formed from a material having a thermal conductivity which is within abount 20% that of copper and a coefficient of thermal expansion which is within about 20% that of silicon, said material having a semiconductor device mounted thereon; a plurality of metal leads having short lead fingers which extend into close proximity to said mounting pad, said leads being electrically connected to said device; and an encapsulation enclosing said mounting pad and said semiconductor device and extending laterally beyond said lead fingers such that the ends of the leads extend from said encapsulation as connectors for said packaged semiconductor device.

-3-

## BRIEF DESCRIPTION OF THE DRAWINGS

The invention described herein may be better understood by reference to the following detailed description considered in conjunction with the drawings, wherein:

Fig. 1 is a longitudinal sectional view showing internal elements of a conventional plastic dual in-line package;

Fig. 2 is a transverse sectional view of the package of Fig. 1;

Fig. 3 is a plan view of a conventional lead frame;

Fig. 4 is a plan view of the conventional lead frame of Fig. 2 with its mounting pad 16 removed;

Fig. 5 is a plan view of the lead frame of Fig. 4 with a mounting pad formed from a low expansion, high thermal conductivity material attached thereto;

Fig. 6 is a longitudinal sectional view showing internal elements of the package of the present invention;

Fig. 7 is a transverse sectional view of the package shown in Fig. 6;

Fig. 8 is a longitudinal section view showing internal elements of preferred embodiment of the present invention; and

Fig. 9 is a transverse sectional view of the packaged semiconductor device shown in Fig. 8.


## DESCRIPTION OF A PREFERRED EMBODIMENT

Packages for semiconductor devices are made in a variety of forms such as dual in-line packages, edge mounted packages and flat packs. The present invention is illustrated herein with respect to a dual in-line package, although it is in no way limited to such a configuration.

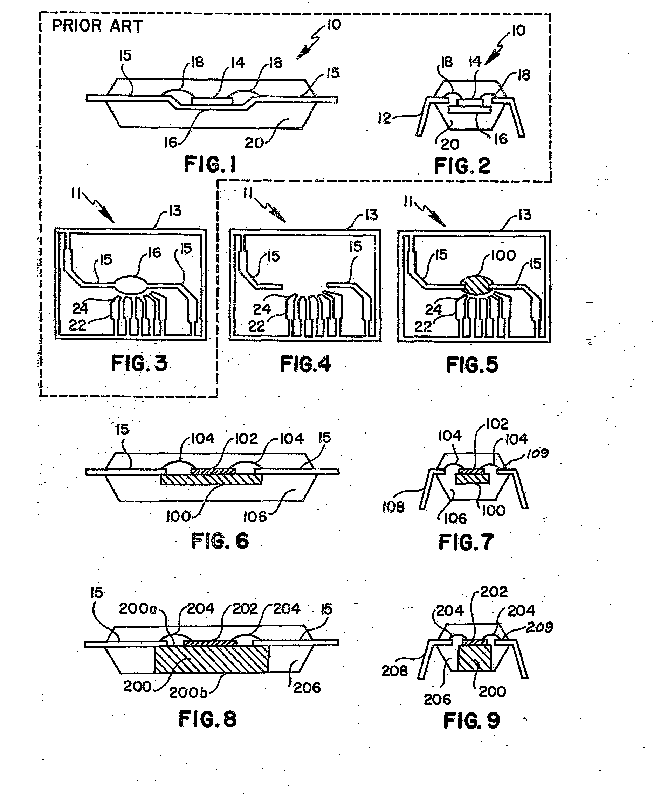

Figs. 1 and 2 show a conventional plastic dual in-line package 10. Mounted within this package are a semiconductor device 14, for example, an integrated circuit device, and a plurality of electrically conducting metal leads 12 which extend from the periphery of the package 10 and are bent over at their ends to form connectors. A package of this type is thus adapted for plugging into a circuit board or the like by inserting the male leads into female receivers formed on the board.

In forming various types of semiconductor packages, including the one shown in Figs. 1 and 2, it is common to utilize a lead frame such as the frame 11 shown in Fig. 3. The frame 11 is formed of thin metal and includes a central mounting pad 16 and at least one pad support member 15 which extends to a rim 13 formed about the frame. Metal leads 22 extend inwardly from the rim 13 into close proximity to the mounting pad 16. The inner portion 24 of these leads are commonly referred to as lead fingers.

In the conventional dual in-line package shown in Figs. 1 and 2, as well as in various other types of packages for semiconductor devices, a semiconductor device 14 is mounted on the central pad 16 and fine wires 18, which typically are either gold or aluminum, are connected between device contacts and the lead fingers 24 of the leads 22. An encapsulation material, for example, an epoxy resin or a high purity silicone plastic, is utilized to encapsulate the device 14 and the wires 18. The encapsulation material may be applied by transfer molding techniques which are well-known in the art. The molding operation is accomplished by the application of heat and pressure to a mold to produce the desired exterior package configuration. The exterior rim 13 of the frame is then removed. In the case of a dual in-line package, the outer ends of the leads 22 are bent as illustrated in Fig. 2 to form a package that may be plugged OR SOLDERED into a circuit board.

The packaged semiconductor device of the present invention is shown in Fig. 6. A mounting pad 100 which is formed from a low expansion, high thermal conductivity

0052054

material has a semiconductor device 102 mounted thereon. The mounting pad material has a thermal conductivity which is within abount 20% that of copper and a coefficient of thermal expansion which is within abount 20% that of silicon. A material of the type just described is manufactered by Semi Alloys Incorporated, Mount Vernon, New York.

Pad support means 15 are attached to the mounting pad 100. A plurality of metal leads 108 having short lead fingers 109 extend into close proximity to the mounting pad 100. The leads 108 are electrically connected to the semiconductor device 102 by wires 104. A plastic encapsulation 106 encloses the mounting pad 100 and the semiconductor device 102 and extends laterally beyond the lead fingers 109 such that the ends of the leads 108 extend from the encapsualtion 106 as connectors for the packaged semiconductor device (Fig. 7).

Conventional lead frames such as that shown in Fig. 3 may be utilized in the manufacture of the packaged semiconductor device of the present invention by adding one punch station to remove the mounting pad 16 thereof as illustrated in Fig. 4. The lead frame can be manufactured from a low cast material such as cold-rolled steel. Lead frames formed of cold-rolled steel would result in not only improved thermal conductance through the lead frame but also extended life of the stamping tool.

Following removal of the mounting pad 16, the thermally conducting material 100 is attached to the remaining and support means 15 by welding, diffusion bond, or other well known techniques.

Fig. 8 and 9 show a preferred embodiment of the packaged semiconductor device of the present invention. A mounting pad 200 formed from the above-described low expansion, high thermal conductivity material has an upper surface 200a and a lower surface 200b. A semiconductor device 202 is mounted centrally on the upper surface 200a of mounting pad 200. Pad support means 15 are attached to the mounting pad 200 at the periphery of its upper surface 200a. A plurality of metal leads 208 having short lead fingers 209 extend into close proximity to the mounting pad 200. The leads 208 are electrically connected to the semiconductor device 202 by wires 204. An encapsulation 206 encloses the mounting pad 200 such that the upper surface 200a of the mounting pad 200 and the semiconductor device 202 are encapsulated while the lower surface 200b of the mounting pad 200 is exposed to an operational environment. As shown in Fig. 8 and 9, it is preferred that the lower surface of the encapsulation 206 be coplanar with the lower surface 200b of the mounting pad 200. The operational environment may be either still air or moving air.

The structure shown in Figs. 8 and 9 exposes the high thermal conductivity material to the assembly environment and provides a superior thermal path for dissipation of heat generated in device operation.

The packaged semiconductor device of the present invention provides several advantages over prior art devices such as lower cost as compared to ceramic packages, the

-8-

ability to utilize existing tooling in its maintenance, and the ability to package higher power devices in plastic.

-9-

I Claim:

1.  A packaged semiconductor device characterized by:

(A).  a mounting pad formed from a material having a thermal conductivity which is within about 20% that of copper and a coefficient of thermal expansion which is within about 20% that of silicon, said material having a semiconductor device mounted thereon;

(B)  a plurality of metal leads having short lead fingers which extend into close proximity to said mounting pad, said leads being electrically connected to said device; and

(C)  an encapsulation enclosing said mounting pad and said semiconductor device and extending laterally beyond said lead fingers such that the ends of the leads extend from said encapsulation as connectors for said packaged semiconductor device.

2.  A packaged semiconductor device according to claim 1 characterized by mounting pad support means attached to said mounting pad.

3.  A packaged semiconductor device according to claim 1 or 2 characterized in that said metal leads are cold-rolled steel.

4.  A packaged semiconductor device according to any one of claims 1-4 characterized in that said encapsulation is plastic.

5.  A packaged semiconductor device according to any preceding claim characterized in that said semiconductor device is mounted on the upper surface of

-10-

said mounting pad; and said encapsulation encloses said mounting pad such that said upper surface of said mounting pad and said semiconductor device are encapsulated while said lower surface of said mounting pad is exposed to an operational environment.

6. A packaged semiconductor device according to claim 5 characterized in that said semiconductor device is centrally located on said upper surface of said mounting pad and characterized by pad support means attached to said mounting pad at the periphery of the upper surface thereof.

7. A packaged semiconductor device according to claim 5 or 6 characterized in that said operational environment is still air.

8. A packaged semiconductor device according to claim 5 or 6 characterized in that said operational environment is moving air.

9. A packaged semiconductor device according to claim 5, 6, or 7 characterized in that the lower surface of said encapsulation is coplanar with the lower surface of said mounting pad.

0052054

1/1

PRIOR ART

FIG.1

FIG.2

FIG.3

FIG.4

FIG.5

FIG.6

FIG.7

FIG.8

FIG.9

0052054

## European Patent Office

**EUROPEAN SEARCH REPORT**

Application number

EP 81 40 1759

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| Y | US - A - 3 839 660 (GENERAL MOTORS)<br><br>* figure 1; column 2, lines 27-38, 17-48; column 3, lines 12-15, 60-66 * | 1-7,9 | H 01 L 23/30<br>23/48//<br>23/36 |
| Y | US - A - 4 026 008 (SIGNETICS)<br><br>* figures 28,29; column 14, lines 18-47 * | 1,4,5,7 | |
| A | US - A - 4 055 062 (ALLEGHENY LUDLUM)<br><br>* claim 1 * | 1,3 | TECHNICAL FIELDS SEARCHED (Int.Cl. 3)<br><br>H 01 L |
| A | ELECTRONIC DESIGN, volume 29, no. 8, April 16, 1981 DENVILLE (US) R. SHINN "DIP configuration aids heat dissipation of low-power MOSFETs", pages 48-49<br><br>* figure page 48 * | 8 | |

CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons
&: member of the same patent family, corresponding document

The present search report has been drawn up for all claims

| Place of search | Date of completion of the search | Examiner |
|---|---|---|
| The Hague | 25-02-1982 | DE RAEVE |

EPO Form 1503.1 06.78